(19) Europäisches Patentamt
European Patent Office
Office européen des brevets

(11) **EP 2 345 905 B1**

(12) **EUROPEAN PATENT SPECIFICATION**

(45) Date of publication and mention
of the grant of the patent:
**03.08.2016 Bulletin 2016/31**

(51) Int Cl.:
***G01R 31/36*** *(2006.01)*

(21) Application number: **10197399.8**

(22) Date of filing: **30.12.2010**

(54) **Battery characteristic evaluator**

Batterieeigenschaftsauswertungseinrichtung

Évaluateur de caractéristiques de batterie

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.01.2010 JP 2010002803**

(43) Date of publication of application:
**20.07.2011 Bulletin 2011/29**

(73) Proprietor: **Yokogawa Electric Corporation Tokyo 180-8750 (JP)**

(72) Inventors:
• **Hamano, Satoshi**
**Musashino-shi Tokyo 180-8750 (JP)**
• **Nakagomi, Masaru**
**Musashino-shi Tokyo 180-8750 (JP)**
• **Kazumi, Masahiro**
**Musashino-shi Tokyo 180-8750 (JP)**
• **Yoshitake, Satoshi**
**Musashino-shi Tokyo 180-8750 (JP)**

(74) Representative: **Grünecker Patent- und Rechtsanwälte PartG mbB Leopoldstraße 4 80802 München (DE)**

(56) References cited:
US-A- 6 118 275        US-A- 6 167 349
US-A1- 2001 035 739     US-A1- 2002 109 504
US-A1- 2004 128 088     US-A1- 2008 048 662

• **NEUMANN-SPALLART M ET AL: "Calculation of impedance spectra by Laplace transformation of voltage transients generated by current-step excitation", JOURNAL OF ELECTROANALYTICAL CHEMISTRY AND INTERFACIAL ELECTROCHEMISTRY, ELSEVIER, AMSTERDAM, NL, vol. 372, no. 1-2, 8 July 1994 (1994-07-08), pages 33-37, XP026577869, ISSN: 0022-0728, DOI: 10.1016/0022-0728(93)03265-Q [retrieved on 1994-07-08]**

**Description**

BACKGROUND

Technical Field

The present invention relates to a battery characteristic evaluator..

Related Art

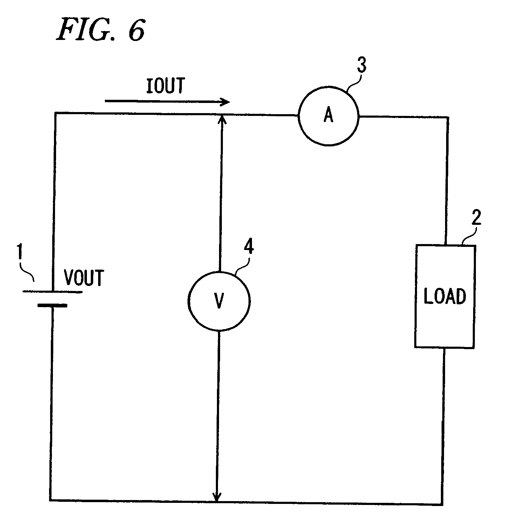

Fig. 6 is a block diagram illustrating the configuration of a related-art circuit used in measuring current and voltage to evaluate battery characteristics. A load 2 and an ammeter 3 are connected in series to a battery 1 as a measurement target and a voltmeter 4 is connected in parallel to the battery 1.

The ammeter 3 measures a rising or falling value of output current of the battery 1 varying depending on the turning-on/off of the load 2, and the voltmeter 4 measures a rising or falling value of output voltage of the battery 1 varying depending on the turning-on/off of the load 2. Such a specific measurement procedure is described in JP-A-2003-4780.

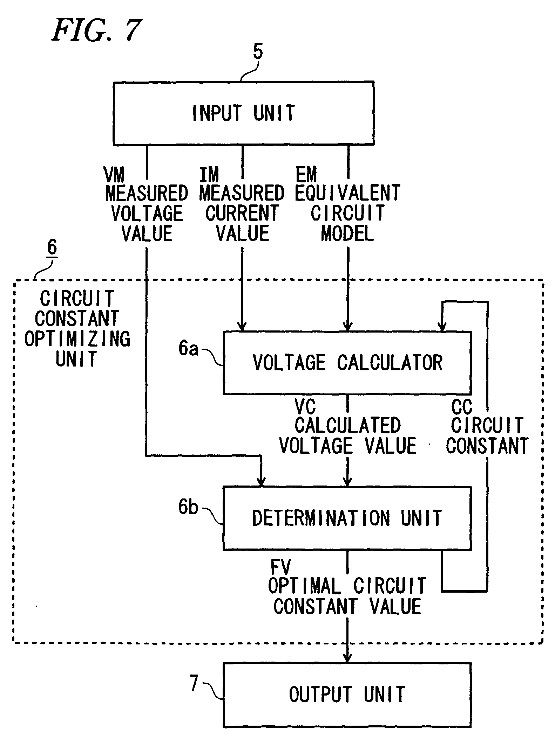

Fig. 7 is a block diagram illustrating the configuration of a related-art battery characteristic evaluator for evaluating battery characteristics of a battery based on the measurement result of Fig. 6. Current value data IM measured by the ammeter 3, voltage value data VM measured by the voltmeter 4, and standard equivalent circuit model data EM of the battery 1 prepared in advance are input to an input unit 5.

A circuit constant optimizing unit 6 includes a voltage calculator 6a and a determination unit 6b, optimizes a circuit constant of an equivalent circuit model of the battery 1 as an identification value FV based on the current value data IM measured by the ammeter 3, the voltage value data VM measured by the voltmeter 4, and the equivalent circuit model data EM of the battery 1 which are input from the input unit 5, and outputs the optimized circuit constant of the equivalent circuit model to an output unit 7.

In the circuit constant optimizing unit 6, the current value data IM measured by the ammeter 3, the equivalent circuit model data EM of the battery 1, and a candidate of the circuit constant CC from the determination unit 6b are input to the voltage calculator 6a, and a calculated voltage value VC is calculated and provided to the determination unit 6b.

The voltage value data VM measured by the voltmeter 4 and the calculated voltage value VC calculated by the voltage calculator 6a are input to the determination unit 6b. The measured voltage value data VM and the calculated voltage value VC are compared with each other and it is determined whether the circuit constant is the optimal value. When it is determined that the circuit constant is not the optimal value, a new circuit constant CC is generated from the comparison result and is input to the voltage calculator 6a, and the voltage is calculated again. These processes are repeatedly performed until it is determined that the circuit constant is the optimal value. The identification value FV optimized as the circuit constant of the equivalent circuit model in this way is provided to the output unit 7.

The output unit 7 generates a characteristic curve of the battery 1 based on the identification value FV of the circuit constant of the equivalent circuit model optimized by the circuit constant optimizing unit 6 and displays the generated characteristic curve on a display unit (not shown).

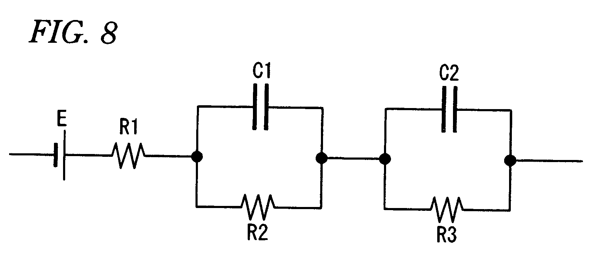

Fig. 8 is a diagram illustrating an equivalent circuit representing the characteristics of the battery 1. In the equivalent circuit shown in Fig. 8, a DC source E, a resistor R1, a parallel circuit of a resistor R2 and a capacitor C1, and a parallel circuit of a resistor R3 and a capacitor C2 are connected in series.

When circuit data shown in Fig. 8 is input as the equivalent circuit model data EM, the circuit constant optimizing unit 6 calculates resistance values R1, R2, and R3 of the resistors and capacitance values C1 and C2 of the capacitors so as to reduce a difference between the calculated voltage value and the measured voltage value.

JP-A-2003-4780 discloses the configuration of method and apparatus for measuring internal impedance of a battery.

JP-A-2005-100969 discloses removing an influence of a response voltage due to polarization at the time of measuring internal impedance of a battery.

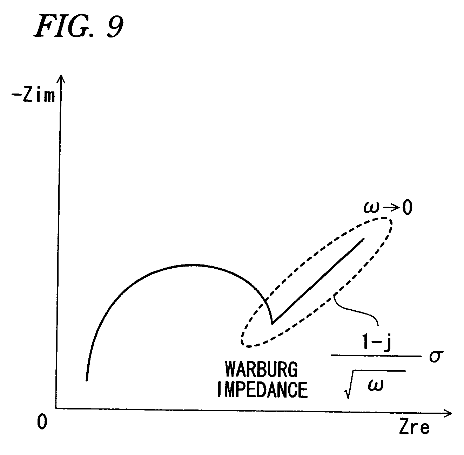

In a low-frequency region of impedance of the battery 1, Warburg impedance is exhibited due to the influence of diffusion. The Warburg impedance may be calculated as impedance in a frequency domain as shown in Fig. 9, but it is difficult to transform the impedance in the frequency domain into impedance in a time domain. Accordingly, the Warburg impedance in the related-art equivalent circuit is expressed by a resistor, a capacitor, and an inductor.

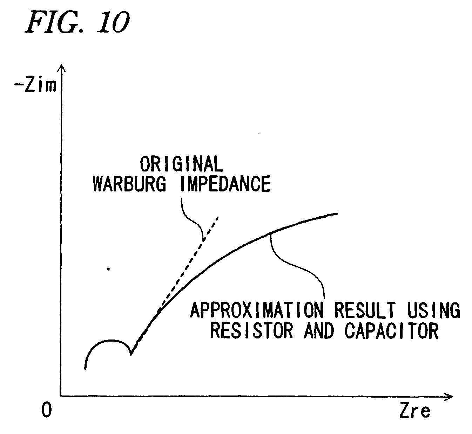

However, a voltage drop curve based on the Warburg impedance could not be reproduced by the combination of a resistor and a capacitor. Nevertheless, when the identification thereof is performed using a DC source, a resistor, and a capacitor, the resistance value of the resistor or the capacitance value of the capacitor becomes a large value that does not correspond to reality as shown in Fig. 10, thereby making the circuit constant identification meaningless.

US 2004/0128088 A1 relates to detecting and analyzing time-varying electrochemical or electrical response after the application of time varying electrical excitation(s) to a system containing biologic and/or non-biologic elements. Labeling or marker techniques may be employed, whereby electrochemically active auxiliary molecules are attached to the substance to be analyzed, in order to facilitate or enhance the electrochemical or electrical response. The method may also be employed to test non-biologic systems comprising an electrochemical cell or a battery of cells, wherein complex pulse type excitation signals are applied to the cell and the resultant time varying polarization voltage information is extracted and analyzed to determine at least one characteristic of the cell(s) condition or state.

US 6,118,275 relates to a method for measuring a battery capacity using a voltage response signal based on a pulse current previously applied to the battery. In particular, the taught method considers the voltage characteristic in the response to the applied pulse current.

SUMMARY OF THE INVENTION

Exemplary embodiments of the present invention address the above disadvantages and other disadvantages not described above. However, the present invention is not required to overcome the disadvantages described above, and thus, an exemplary embodiment of the present invention may not overcome any disadvantages.

Accordingly, it is an illustrative aspect of the present invention to provide a battery characteristic evaluator which can improve precision of a circuit constant identification value in an equivalent circuit model of a battery in view of Warburg impedance.

According to one or more illustrative aspects of the present invention, there is provided a battery characteristic evaluator configured to identify a circuit constant of an equivalent circuit model based on a current-voltage characteristic of a battery. The evaluator includes: a current waveform divider configured to divide a certain current waveform into a plurality of step functions with a plurality of infinitesimal time intervals and output the step functions; and a circuit constant optimizing unit configured to calculate the optimized circuit constant of the equivalent circuit model, based on the step functions, a measured voltage value, and equivalent circuit model data.

Other aspects and advantages of the present invention will be apparent from the following description, the drawings and the claims.

BRIEF DESCRIPTION OF THE DRAWINGS

Fig. 1 is a block diagram illustrating an example of the invention;
Figs. 2A to 2H are diagrams illustrating an operation of dividing a certain waveform current into step functions;
Figs. 3A to 3C are diagrams illustrating a recombination by the superposition of step responses in the circuit shown in Figs. 2A to 2H, excluding a power source;
Fig. 4 is a diagram illustrating an equivalent circuit including Warburg impedance, which represents a battery characteristic;
Fig. 5 is a diagram illustrating an equivalent circuit in which the Warburg impedance W1 is singly connected in series;
Fig. 6 is a block diagram illustrating the configuration of a related-art circuit used in measuring current and voltage to evaluate the battery characteristic;
Fig. 7 is a block diagram illustrating a related-art battery characteristic evaluator for evaluating the battery characteristic based on the measurement result of Fig. 6;
Fig. 8 is a diagram illustrating an equivalent circuit representing the battery characteristic;
Fig. 9 is a diagram illustrating the Warburg impedance; and
Fig. 10 is a diagram illustrating an example where the Warburg impedance is approximated by a resistor and a capacitor.

DETAILED DESCRIPTION OF EXEMPLARY EMBODIMENTS

Hereinafter, exemplary embodiments of the present invention will be described with reference to the accompanying drawings.

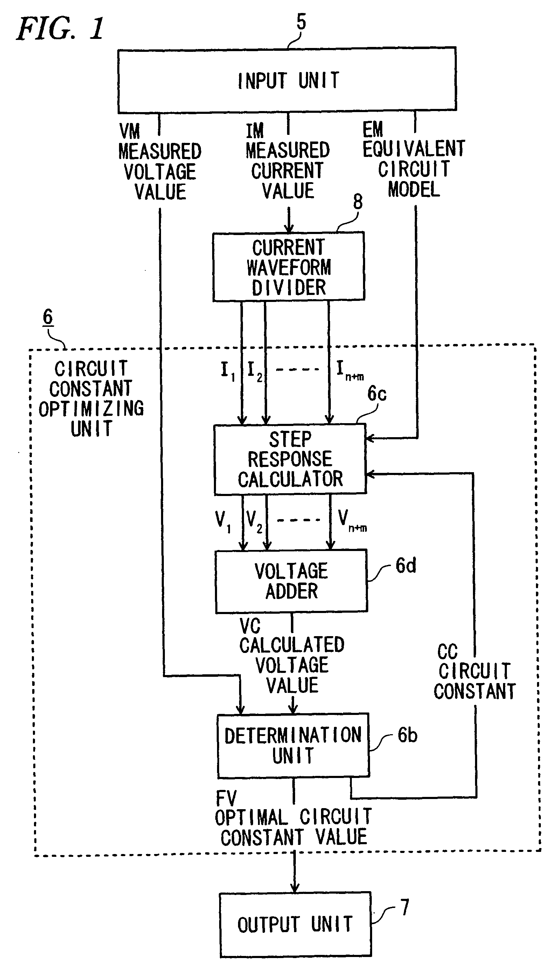

Fig. 1 is a block diagram illustrating an embodiment of the invention, where elements common to those shown in Fig. 7 are referenced by like reference numerals and signs.

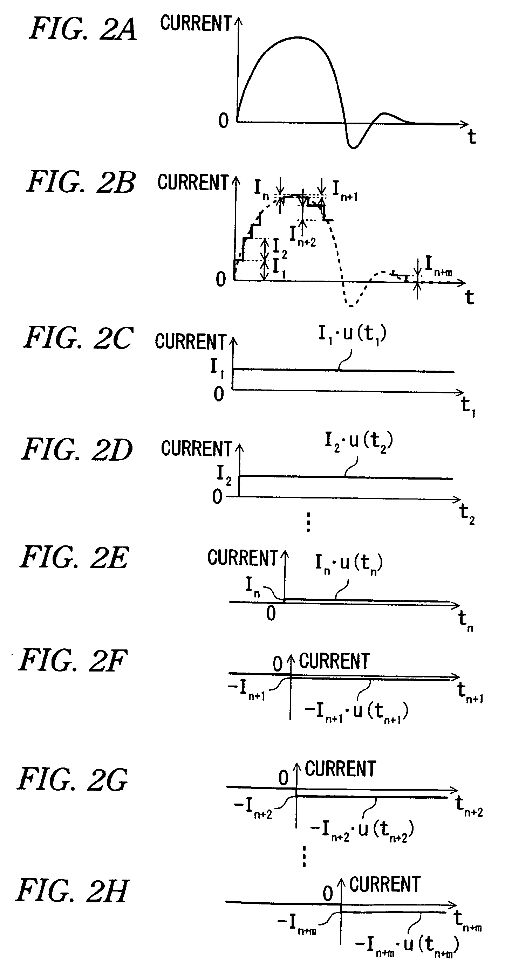

In Fig. 1, a current waveform divider 8 divides a measured value 1M of a certain current waveform into plural step functions having different time axes as shown in Fig. 2. Fig. 2 shows an example where a rising region of a current waveform is divided into n step functions $I_1$ to $I_n$ and a falling region is divided into m step functions $I_{n+1}$ to $I_{n+m}$. The step functions $I_1$ to $I_{n+m}$ are input to a circuit constant optimizing unit 6.

In the circuit constant optimizing unit 6, a step response calculator 6c and a voltage adder 6d adding the

response calculation results $V_1$ to $V_{n+m}$ of the step response calculator 6c are provided instead of the voltage calculator 6a of Fig. 7.

Equivalent circuit model data EM, a candidate of a circuit constant CC from a determination unit 6b, and the step functions $I_1$ to $I_{n+m}$ corresponding to the current from the current waveform divider 8 are input to the step response calculator 6c. Accordingly, the step response calculator 6c calculates step response voltages $V_1$ to $V_{n+m}$ for the current given as the step functions $I_1$ to $I_{n+m}$ and inputs the step response voltages $V_1$ to $V_{n+m}$ as the calculation results to an input terminal of the voltage adder 6d.

The voltage adder 6d adds the step response voltages $V_1$ to $V_{n+m}$ as the calculation results of the step response calculator 6c to obtain a calculated voltage value VC. Then, the calculated voltage value VC is provided to the determination unit 6b.

Voltage value data VM measured by a voltmeter 4 and the calculated voltage value VC calculated by the voltage adder 6d are input to the determination unit 6b. The measured voltage value VM and the calculated voltage value VC are compared to determine whether the circuit constant is the optimal value as the comparison result. When it is determined that the circuit constant is not the optimal value, a new circuit constant CC is generated from the comparison result and is input to the step response calculator 6c so as to calculate a voltage again. These processes are repeatedly performed until it is determined that the circuit constant is the optimal value. An identification value FV optimized as the circuit constant of the equivalent circuit model in this way is provided to an output unit 7.

The output unit 7 generates a characteristic curve of the battery 1 based on the identification value FV of the circuit constant of the equivalent circuit model optimized by the circuit constant optimizing unit 6 and displays the generated characteristic curve on a display unit (not shown).

The details shown in Figs. 2A to 2H will be described below. The rising region p of the certain waveform current I(t) shown in Fig. 2A is divided into n step functions as shown in Figs. 2B to 2H, and the falling region n is divided into m step functions. This can be expressed by a mathematical expression as follows. Here, u(t) represents a unit step function with amplitude 1.

$$I(t) = I_1 \cdot u(t-b_1) + I_2 \cdot u(t-b_2) + I_3 \cdot u(t-b_3) + \ldots + I_n \cdot u(t-b_n) - I_{n+1} \cdot u(t-b_{n+1}) - I_{n+2} \cdot u(t-b_{n+2}) - \ldots - I_{n+m} \cdot u(t-b_{n+m}) = I_1 \cdot u(t_1) + I_2 \cdot u(t_2) + I_3 \cdot u(t_3) + \ldots + I_n \cdot u(t_n) - I_{n+1} \cdot u(t_{n+1}) + I_{n+2} \cdot u(t_{n+2}) + \ldots + I_{n+m} \cdot u(t_{n+m}), \quad \ldots(1)$$

where u(t) is set so that $u(t_i) = 0$ (if $t_i < 0$) and 1 (if $t_i \geq 0$) at time $t_i$ (where $i = 1$ to $n + m$).

In Expression 1, $I_i(t_i)$ (where $I = 1$ to $n$) can be expressed as follows by the Laplace transform.

$$I_i(s) = L(I_i \cdot u(t-b_i)) = I_i \cdot (1/s) \quad \ldots(2)$$

Similarly, $I_i(t_i)$ (where $i = n + 1$ to $n + m$) can be also expressed as follows by the Laplace transform.

$$I_i(s) = - L(I_i \cdot u(t-b_i)) = - I_i \cdot (1/s) \quad \ldots(3)$$

Since these current signals flow in impedance Z(s) and are thus converted into voltages, the voltages $V_i(s)$ (where $i = 1$ to $n + m$) based on the currents are expressed as follows.

$$V_i(s) = Z(s) \cdot I_i \cdot 1/s \ (\text{if } i = 1 \text{ to } n)$$

$$V_i(s) = - Z(s) \cdot I_i \cdot 1/s \ (\text{if } i = n + 1 \text{ to } m) \quad \ldots(4)$$

When step current flows in impedance Z, transient voltage response signals $V_i(t_i)$ are obtained as follows by the Laplace-transforming Expression (4).

$$V_i(t_i) = L[V_i(s)] = I_i \cdot L[Z(s) \cdot 1/s] \text{ (if } i = 1 \text{ to } n)$$

$$V_i(t_i) = L[V_i(s)] = - I_i \cdot L[Z(s) \cdot 1/s] \text{ (if } i = n+1 \text{ to } m) \quad \dots(5)$$

Therefore, by recombining the step responses divided into (n + m) steps, a transient voltage response waveform V(t) when a certain current waveform flows in the impedance Z can be expressed by Expression (6).

$$V(t) = V_1(t_1) + V_2(t_2) + V_3(t_3) + \dots + V_n(t_n) - V_{n+1}(t_{n+1}) - V_{n+2}(t_{n+2})\dots -$$

$$V_{n+m}(t_{n+m}) \qquad\qquad \dots(6)$$

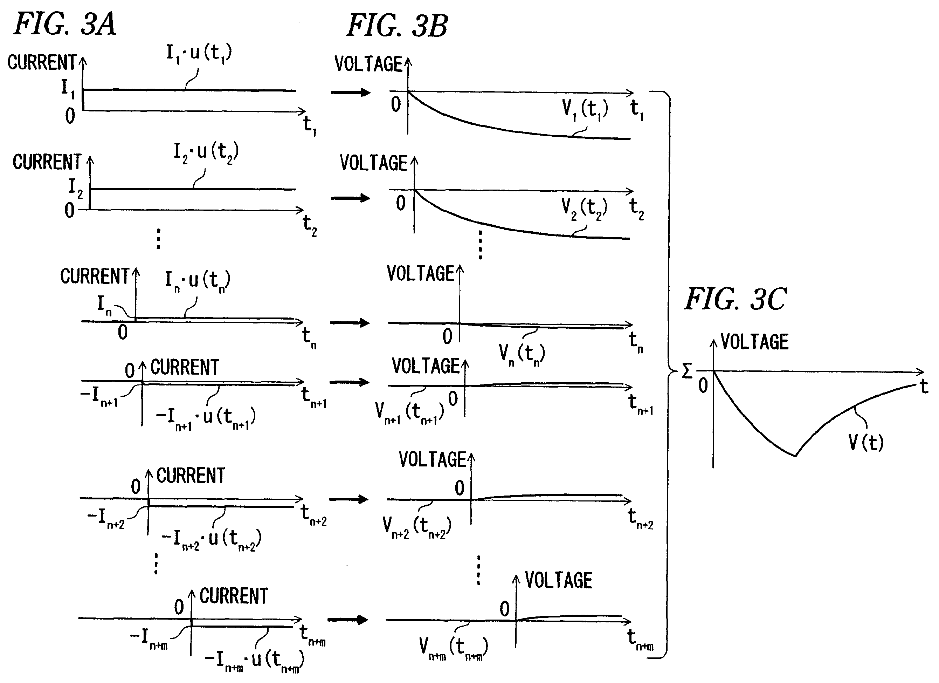

Accordingly, even when a certain current waveform is input, it is possible to calculate a voltage response of the battery. Figs. 3A to 3C are diagrams illustrating the recombination based on the superposition of the step responses in the circuit shown in Fig. 1, excluding the power source. In Figs. 3A to 3C, Fig. 3A shows the step functions of a certain current waveform, Fig. 3B shows the step responses, and Fig. 3C shows the superposition of the step responses.

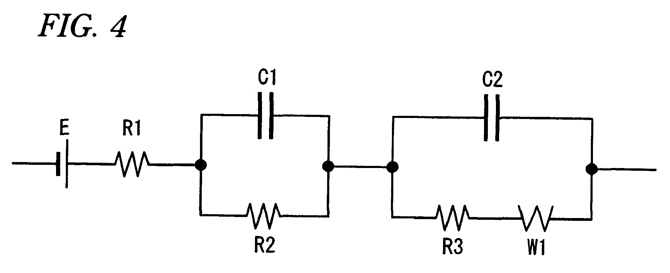

Fig. 4 is a diagram illustrating an equivalent circuit including the Warburg impedance representing the battery characteristic. In Fig. 4, a DC source E, a resistor R1, a parallel circuit of a resistor R2 and a capacitor C1, and a parallel circuit of a series circuit of a resistor R3 and a Warburg impedance W1 representing the diffusion of materials and a capacitor C2 are connected in series.

According to this configuration, the Warburg impedance can be included in the equivalent circuit and the identification precision of the battery increases, thereby making the current-voltage characteristic closer to reality. Realistic values can be obtained for the circuit constants other than the Warburg impedance.

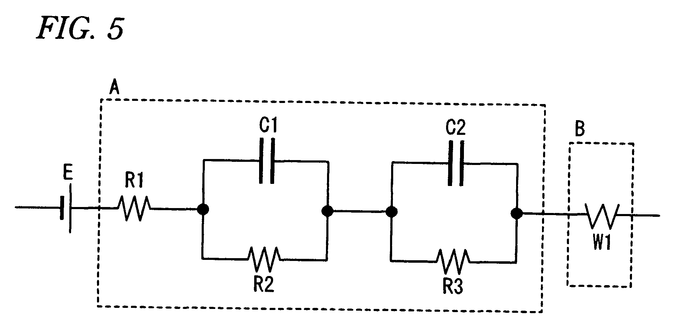

Although the equivalent circuit model in which the Warburg impedance is connected in parallel has been described in the above-mentioned embodiment, an equivalent circuit in which the Warburg impedance W1 is singly connected in series as shown in Fig. 5 can be implemented by easy calculation.

In Fig. 5, the conventional method is applied to the voltage in a circuit block in which an RLC circuit is connected in series and the method according to the invention is applied to the voltage in a Warburg impedance block.

In this case, the voltage Vw in the time domain of the Warburg impedance block W1 can be calculated as follows and thus the calculation is simplified.

$$Vw = (\delta\sqrt{2t}) \times Ip/\Gamma(3/2), \qquad\qquad \dots(7)$$

where $\delta$ represents a constant of diffusion and $\Gamma$ represents a gamma function.

The total voltage of the equivalent circuit shown in Fig. 5 is calculated as the sum of the voltage in the Warburg impedance W1 block and the voltage in the RLC circuit block. The voltages calculated by the methods are compared with the measured voltage value for evaluation.

The method according to the invention can be applied when the input current has a rectangular waveform.

In the above-mentioned embodiment, the current is changed and identified with the measured response voltage, but the voltage may be changed and identified with the measured current value.

According to the above-mentioned invention, it is possible to provide a battery characteristic evaluator which can identify a circuit constant with high precision in an equivalent circuit model of a battery in consideration of the Warburg impedance so as to evaluate a battery characteristic with high precision, and can be suitably used to efficiently analyze various parameters of a battery.

## Claims

1. A battery characteristic evaluator configured to identify a circuit constant of an equivalent circuit model based on a current-voltage characteristic of a battery, the evaluator comprising:

   a current waveform divider (8) configured to divide a certain current waveform into a plurality of step functions with a plurality of infinitesimal time intervals and to output the step functions; and
   a circuit constant optimizing unit (6) configured to calculate an optimized circuit constant (FV) of the equivalent circuit model, based on the step functions, a measured voltage value (VM), and equivalent circuit model data (EM);

**characterized in that** the circuit constant optimizing unit (6) comprises:

a step response calculator (6c) configured to calculate a plurality of step response voltages each corresponding to one of the plurality of step functions, based on the plurality of step functions and the equivalent circuit model data (EM);
a voltage adder (6d) configured to add each of the step response voltages to output a calculated voltage value (VC); and
a determination unit (6b) configured to determine whether a circuit constant (CC) is the optimal value, by comparing the calculated voltage value (VC) with the measured voltage value (VM),
wherein when the determination unit (6b) determines that the circuit constant (CC) is not the optimal value, the determination unit (6b) is further configured to generate a new circuit constant (CC) based on the comparison result, and to provide the new circuit constant (CC) to the step response calculator (6c).

2. A battery characteristic evaluator configured to identify a circuit constant of an equivalent circuit model based on a current-voltage characteristic of a battery, the evaluator comprising:

a voltage waveform divider (8) configured to divide a certain voltage waveform into a plurality of step functions with a plurality of infinitesimal time intervals and to output the step functions; and
a circuit constant optimizing unit (6) configured to calculate an optimized circuit constant (FV) of the equivalent circuit model, based on the step functions, a measured current value, and equivalent circuit model data (EM);

**characterized in that** the circuit constant optimizing unit (6) comprises:

a step response calculator (6c) configured to calculate a plurality of step response currents each corresponding to one of the plurality of step functions, based on the plurality of step functions and the equivalent circuit model data (EM);
a current adder (6d) configured to add each of the step response currents to output a calculated current value; and
a determination unit (6b) configured to determine whether a circuit constant (CC) is the optimal value, by comparing the measured current value with the calculated current value,
wherein when the determination unit (6b) determines that the circuit constant (CC) is not the optimal value, the determination unit (6b) is further configured to generate a new circuit constant (CC) based on the comparison result, and to provide the generated circuit constant (CC) to the step response calculator (6c).

3. The evaluator of claim 1 or 2, wherein the equivalent circuit model comprises Warburg impedance.

**Patentansprüche**

1. Batteriecharakteristik-Auswertungseinrichtung, die ausgebildet ist, eine Schaltungskonstante eines äquivalenten Schaltungsmodells auf der Grundlage einer Strom-Spannungs-Charakteristik einer Batterie zu ermitteln, wobei die Auswertungseinrichtung umfasst:

eine Stromsignalunterteilungseinheit (8), die ausgebildet ist, ein gewisses Stromsignal in mehrere Stufenfunktionen mit mehreren infinitesimalen Zeitintervallen zu unterteilen und die Stufenfunktionen auszugeben; und
eine Schaltungskonstante-Optimierungseinheit (6), die ausgebildet ist, eine optimierte Schaltungskonstante (FV) des äquivalenten Schaltungsmodells auf der Grundlage der Stufenfunktionen, eines gemessenen Spannungswertes (VM) und von äquivalenten Schaltungsmodelldaten (EM) zu berechnen;

**dadurch gekennzeichnet, dass** die Schaltungskonstante-Optimierungseinheit (6) umfasst:

eine Stufenantwortberechnungseinheit (6c), die ausgebildet ist, mehrere Stufenantwortspannungen, die jeweils einer der mehreren Stufenfunktionen entsprechen, auf der Grundlage der mehreren Stufenfunktionen und der äquivalenten Schaltungsmodelldaten (EM) zu berechnen;
einen Spannungsaddierer (6d), der ausgebildet ist, jede der Stufenantwortspannungen zum Ausgeben eines berechneten Spannungswertes (VC) zu addieren; und
eine Ermittlungseinheit (6b), die ausgebildet ist zu ermitteln, ob eine Schaltungskonstante (CC) der optimale Wert ist, indem der berechnete Spannungswert (VC) mit dem gemessenen Spannungswert (VM) verglichen wird,

wobei, wenn die Ermittlungseinheit (6b) ermittelt, dass die Schaltungskonstante (CC) nicht der optimale Wert ist, die Ermittlungseinheit (6b) weiter ausgebildet ist, eine neue Schaltungskonstante (CC) auf der Grundlage des Vergleichsergebnisses zu erzeugen und die neue Schaltungskonstante (CC) der Stufenantwortberechnungseinheit (6c) zuzuführen.

2. Batteriecharakteristik-Auswertungseinrichtung, die ausgebildet ist, eine Schaltungskonstante eines äquivalenten Schaltungsmodells auf der Grundlage einer Strom-Spannungs-Charakteristik einer Batterie zu ermitteln, wobei die Auswertungseinrichtung umfasst:

eine Spannungssignalunterteilungseinheit (8), die ausgebildet ist, ein gewisses Spannungssignal in mehrere Stufenfunktionen mit mehreren infinitesimalen Zeitintervallen zu unterteilen und die Stufenfunktionen auszugeben; und
eine Schaltungskonstante-Optimierungseinheit (6), die ausgebildet ist, eine optimierte Schaltungskonstante (FV) des äquivalenten Schaltungsmodells auf der Grundlage der Stufenfunktionen, eines gemessenen Stromwertes und von äquivalenten Schaltungsmodelldaten (GM) zu berechnen;

dadurch gekennzeichnet, dass die Schaltungskonstante-Optimierungseinheit (6) umfasst:

eine Stufenantwortberechnungseinheit (6c), die ausgebildet ist, mehrere Stufenantwortströme, die jeweils einer der mehreren Stufenfunktionen entsprechen, auf der Grundlage der mehreren Stufenfunktionen und der äquivalenten Schaltungsmodelldaten (GM) zu berechnen;
einen Stromaddierer (6d), der ausgebildet ist, alle Stufenantwortströme zum Ausgeben eines berechneten Stromwertes zu addieren; und
eine Ermittlungseinheit (6b), die ausgebildet ist zu ermitteln, ob eine Schaltungskonstante (CC) der optimale Wert ist, indem der gemessene Stromwert mit dem berechneten Stromwert verglichen wird,

wobei, wenn die Ermittlungseinheit (6b) ermittelt, dass die Schaltungskonstante (CC) nicht der optimale Wert ist, die Ermittlungseinheit (6b) weiter ausgebildet ist, eine neue Schaltungskonstante (CC) auf der Grundlage des Vergleichsergebnisses zu erzeugen und die erzeugte Schaltungskonstante (CC) der Stufenantwortberechnungseinheit (6c) zuzuführen.

3. Auswertungseinrichtung nach Anspruch 1 oder 2, wobei das äquivalenten Schaltungsmodell eine Warburg-Impedanz umfasst.

**Revendications**

1. Évaluateur de caractéristiques de batterie configuré pour identifier une constante de circuit d'un modèle de circuit équivalent en se fondant sur la caractéristique courant-tension d'une batterie, l'évaluateur comprenant :

un diviseur de forme d'onde de courant (8) configuré pour diviser une certaine forme d'onde de courant en une pluralité de fonctions en échelon avec une pluralité d'intervalles de temps infinitésimaux et pour fournir en sortie les fonctions en échelon ; et
une unité d'optimisation de constante de circuit (6) configurée pour calculer une constante de circuit optimisée (FV) du modèle de circuit équivalent, en se fondant sur les fonctions en échelon, une valeur de tension mesurée (VM) et des données de modèle de circuit équivalent (EM) ;

caractérisé en ce que l'unité d'optimisation de constante de circuit (6) comprend :

un calculateur de réponse à un échelon (6c) configuré pour calculer une pluralité de tensions de réponse à un échelon correspondant chacune à une fonction de la pluralité de fonctions en échelon, en se fondant sur la pluralité de fonctions en échelon et sur les données de modèle de circuit équivalent (EM) ;
un additionneur de tension (6d) configuré pour additionner chacune des tensions de réponse à un échelon pour fournir en sortie une valeur de tension calculée (VC) ; et
une unité de détermination (6b) configurée pour déterminer si une constante de circuit (CC) constitue la valeur optimale, en comparant la valeur de tension calculée (VC) à la valeur de tension mesurée (VM),

dans lequel, lorsque l'unité de détermination (6b) détermine que la constante de circuit (CC) n'est pas la valeur optimale, l'unité de détermination (6b) est configurée en outre pour générer une nouvelle constante de circuit (CC) en se fondant sur le résultat de la comparaison, et pour fournir la nouvelle constante de circuit (CC) au calculateur de réponse en échelon (6c).

**2.** Évaluateur de caractéristiques de batterie configuré pour identifier une constante de circuit d'un modèle de circuit équivalent en se fondant sur la caractéristique courant-tension d'une batterie, l'évaluateur comprenant :

un diviseur de forme d'onde de tension (8) configuré pour diviser une certaine forme d'onde de tension en une pluralité de fonctions en échelon avec une pluralité d'intervalles de temps infinitésimaux et pour fournir en sortie les fonctions en échelon ; et
une unité d'optimisation de constante de circuit (6) configurée pour calculer une constante de circuit optimisée (FV) du modèle de circuit équivalent, en se fondant sur les fonctions en échelon, une valeur de courant mesurée et des données de modèle de circuit équivalent (EM) ;

**caractérisé en ce que** l'unité d'optimisation de constante de circuit (6) comprend :

un calculateur de réponse à un échelon (6c) configuré pour calculer une pluralité de courants de réponse à un échelon correspondant chacun à une fonction de la pluralité de fonctions en échelon, en se fondant sur la pluralité de fonctions en échelon et sur les données de modèle de circuit équivalent (EM) ;
un additionneur de courant (6d) configuré pour additionner chacun des courants de réponse à un échelon pour fournir en sortie une valeur de courant calculée ; et
une unité de détermination (6b) configurée pour déterminer si une constante de circuit (CC) constitue la valeur optimale, en comparant la valeur de courant mesurée à la valeur de courant calculée,

dans lequel, lorsque l'unité de détermination (6b) détermine que la constante de circuit (CC) n'est pas la valeur optimale, l'unité de détermination (6b) est configurée en outre pour générer une nouvelle constante de circuit (CC) en se fondant sur le résultat de la comparaison, et pour fournir la nouvelle constante de circuit (CC) au calculateur de réponse en échelon (6c).

**3.** Évaluateur selon la revendication 1 ou 2, dans lequel le modèle de circuit équivalent comprend une impédance de Warburg.

*FIG. 1*

*FIG. 2A*

CURRENT↑

0 ⟶ t

*FIG. 2B*

CURRENT↑

$I_n$   $I_{n+1}$

$I_{n+2}$

$I_2$

$I_1$

$I_{n+m}$

0 ⟶ t

*FIG. 2C*

CURRENT↑

$I_1 \cdot u(t_1)$

$I_1$

0 ⟶ $t_1$

*FIG. 2D*

CURRENT↑

$I_2 \cdot u(t_2)$

$I_2$

0 ⟶ $t_2$

⋮

*FIG. 2E*

CURRENT↑

$I_n \cdot u(t_n)$

$I_n$

0 ⟶ $t_n$

*FIG. 2F*

0↑ CURRENT

$-I_{n+1}$

$-I_{n+1} \cdot u(t_{n+1})$ ⟶ $t_{n+1}$

*FIG. 2G*

0↑ CURRENT

$-I_{n+2}$

$-I_{n+2} \cdot u(t_{n+2})$ ⟶ $t_{n+2}$

⋮

*FIG. 2H*

0↑ CURRENT

$-I_{n+m}$

$-I_{n+m} \cdot u(t_{n+m})$ ⟶ $t_{n+m}$

*FIG. 3A*

*FIG. 3B*

*FIG. 3C*

*FIG. 4*

FIG. 5

*FIG. 6*

*FIG. 7*

5

INPUT UNIT

VM
MEASURED
VOLTAGE
VALUE

IM
MEASURED
CURRENT
VALUE

EM
EQUIVALENT
CIRCUIT
MODEL

6

CIRCUIT
CONSTANT
OPTIMIZING
UNIT

6a — VOLTAGE CALCULATOR

VC
CALCULATED
VOLTAGE VALUE

CC
CIRCUIT
CONSTANT

6b — DETERMINATION UNIT

FV
OPTIMAL CIRCUIT
CONSTANT VALUE

7 — OUTPUT UNIT

*FIG. 8*

## FIG. 9

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003004780 A
- JP 2005100969 A
- US 20040128088 A1
- US 6118275 A